# EUROPEAN PATENT APPLICATION

(11) **EP 4 806 652 A2**
(43) Date of publication of application: **16.09.2026**
(21) Application number: 26163475.2
(22) Date of filing: 10.03.2026
(51) Int. Cl.: B41J 2/14, B41J 2/16, H10N 30/20, H10N 30/87

(54) **PIEZOELECTRIC ACTUATOR AND LIQUID EJECTING HEAD**

(30) Priority: 12.03.2025 JP 2025039372
(71) Applicant: Canon Kabushiki Kaisha, Tokyo 146-8501 (JP)
(72) Inventor: TAZAWA, Shogo, Ohta-ku, Tokyo, 146-8501 (JP); KURASHIMA, Rei, Ohta-ku, Tokyo, 146-8501 (JP); FUKAYA, Youichi, Ohta-ku, Tokyo, 146-8501 (JP)
(74) Representative: TBK

(57) **Abstract**

A piezoelectric actuator includes a first insulation layer (301) provided on a surface of a substrate (100); a conductive layer (302) provided on the first the insulation layer; a second insulation layer (303) provided on the conductive layer; a piezoelectric element (314) provided on a part of the second insulation layer, the piezoelectric element including a first electrode (311), a piezoelectric body (312), and a second electrode (313) in this order; a third insulation layer (320) covering at least a part of the second insulation layer; a first contact plug (321) having one end electrically connected to the conductive layer; a second contact plug (322) having one end electrically connected to the first electrode; and a wiring line (323) provided on the third insulation layer, and electrically connecting another end of the first contact plug and another end of the second contact plug.

## Description

### TECHNICAL FIELD

The present disclosure relates to a piezoelectric actuator and a liquid ejecting head.

### BACKGROUND

In recent years, with the development of micro electro mechanical systems (MEMS) technology, thin-film piezoelectric elements based on semiconductor processes have been proposed, with an application for a liquid ejecting head using a thin-film piezoelectric element. The piezoelectric element drives a piezoelectric body by applying an electric field using electrodes (also referred to as an upper electrode and a lower electrode) formed to sandwich the piezoelectric body from above and below.

Japanese Patent Laid-Open No. 2013-000992 (hereinafter referred to as Literature 1) discusses a liquid ejecting head using a thin-film piezoelectric element. Literature 1 discloses a structure in which an electric field is not generated between a lower electrode and a pressure chamber by grounding a conductive layer provided below a piezoelectric element and electrically insulated from the lower electrode and upper electrode of the piezoelectric element.

In Literature 1, a wiring line connecting the lower electrode and a pad, and a wiring line connecting the upper electrode and the pad are arranged within a surface in which the piezoelectric element is formed, with a dedicated pad portion for electrically grounding the conductive layer.

### SUMMARY

When attempting to arrange a large number of piezoelectric elements, the number of wiring lines drawn from the lower electrode and upper electrodes of the piezoelectric elements and connected to pads is increased. The increase in the number of wiring lines arranged between the piezoelectric elements and the increase in the proportion of the area occupied by the wiring lines prevents the density of piezoelectric elements from being increased.

In order to increase the density of piezoelectric elements, the number of wiring lines arranged within the surface in which the piezoelectric elements are formed is to be reduced. The present disclosure reduces the number of wiring lines in a piezoelectric actuator to arrange piezoelectric elements at high density.

The present disclosure in its first aspect provides a piezoelectric actuator as specified in claim 1. Optional features are specified in claim 2 to 18. The present disclosure in its second aspect provides a liquid ejecting head as specified in claim 19.

According to the present disclosure, in a piezoelectric actuator, the number of wiring lines can be reduced to arrange piezoelectric elements at high density.

Features of the present disclosure will become apparent from the following description of embodiments with reference to the attached drawings. The following description of embodiments is provided by way of example.

### BRIEF DESCRIPTION OF THE DRAWINGS

Fig. 1 is a perspective view schematically illustrating a liquid ejecting apparatus;
Fig. 2A is a plan view schematically illustrating a flow path configuration in a liquid ejecting head;
Fig. 2B is a cross-sectional view schematically illustrating the flow path configuration in the liquid ejecting head;
Fig. 3 is a cross-sectional view schematically illustrating a piezoelectric actuator;
Figs. 4A to 4D are process cross-sectional views for describing manufacturing processes of the piezoelectric actuator;
Fig. 5 is a process cross-sectional views for describing a manufacturing process of the piezoelectric actuator;
Fig. 6 is a cross-sectional view schematically illustrating the piezoelectric actuator;
Fig. 7 is a plan view schematically illustrating the liquid ejecting head;
Fig. 8 is a cross-sectional view schematically illustrating the piezoelectric actuator;
Fig. 9 is a cross-sectional view schematically illustrating the piezoelectric actuator;
Fig. 10A is a plan view schematically illustrating a comparative example of a liquid ejecting head;
Fig. 10B is a cross-sectional view schematically illustrating the comparative example of the liquid ejecting head; and
Fig. 11 is a plan view schematically illustrating a comparative example of a liquid ejecting head.

### DESCRIPTION OF THE EMBODIMENTS

Hereinafter, examples of embodiments of the present disclosure will be described with reference to the drawings. It should be noted that the following embodiments do not limit the present disclosure, and not all combinations of features described in the following embodiments are necessarily essential to the solutions of the present disclosure. The same components are designated with the same numerals.

### <<First Embodiment >>

### <Configuration of Liquid Ejecting Apparatus>

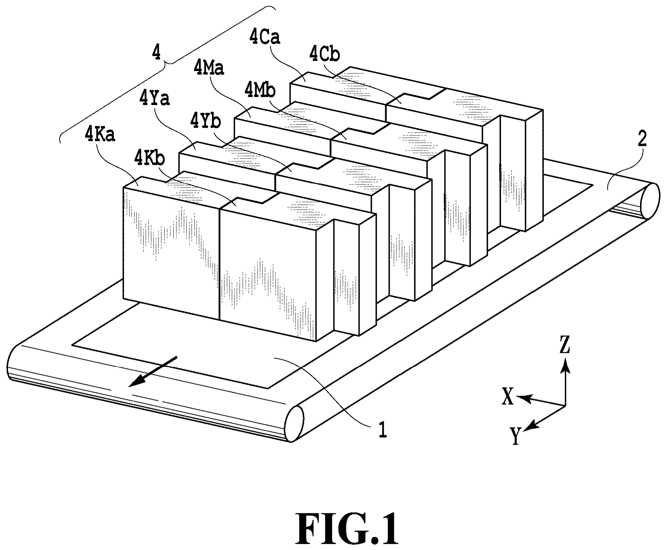

Fig. 1 is a perspective view schematically illustrating a part of a liquid ejecting apparatus. The liquid ejecting apparatus in the present embodiment is a one-pass type liquid ejecting apparatus that prints an image by moving a print medium 1 once. The liquid ejecting apparatus includes a liquid ejecting head 4 as a full-line head in which element substrates having ejection ports for discharging liquid are arranged across a side corresponding to the entire width of the print medium 1. The print medium 1 is conveyed in the +Y direction indicated by the arrow in Fig. 1 by a conveyance unit 2, and printing is performed by the liquid ejecting head 4. The liquid ejecting head 4 in the present embodiment can be implemented in other forms, not limited to the example illustrated in Fig. 1. In the example illustrated in Fig. 1, eight liquid ejecting heads 4 (4Ka, 4Kb, 4Ya, 4Yb, 4Ma, 4Mb, 4Ca, and 4Cb) are mounted on the liquid ejecting apparatus.

As described above, the liquid ejecting head 4 in the present embodiment is a one-pass type, page-wide type head having a length corresponding to the width of the print medium 1. The width of the print medium 1 is in an X direction perpendicular to a conveying direction of the print medium 1. The liquid ejecting head may be a serial-type liquid ejecting head that performs printing while scanning the liquid ejecting head across the print medium. An example of a serial-type liquid ejecting head is a configuration in which one element substrate for black ink and one element substrate for color ink are mounted. Another example of a serial-type liquid ejecting head is a configuration in which several element substrates are arranged so that ejection ports overlap in the arranging direction of ejection port lines, and the width of the configuration is smaller than the print medium.

### <Path Flow Configuration of Liquid Ejecting Head>

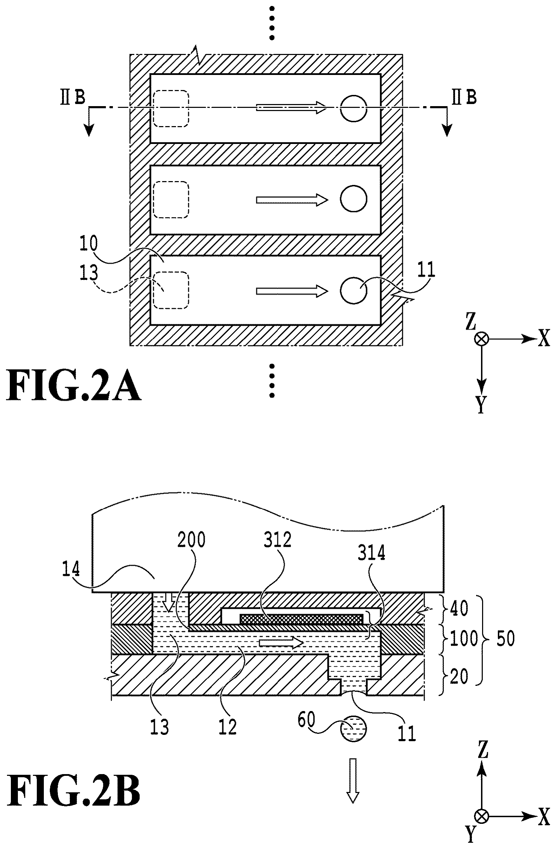

Figs. 2A and 2B are schematic diagrams illustrating the flow path configuration in an element substrate 50 of the liquid ejecting head 4 in the present embodiment. Fig. 2A is a plan view as seen from an ejection port 11 side of a flow path block 10 in the element substrate 50. Fig. 2B is a cross-sectional view taken along line IIb-IIb in Fig. 2A. The element substrate 50 includes three types of substrates, i.e. a first flow path substrate 20, a second flow path substrate 100, and a third flow path substrate 40, which are combined to form a flow path. As illustrated in Fig. 2A, the flow path blocks 10 include the ejection ports 11 arranged along a Y direction, and pressure chambers 12 and supply flow paths 13 that are provided to communicate with respective ejection ports 11. In addition, each of the supply flow paths 13 connected to a common liquid chamber 14 supplies liquid (hereinafter also referred to as ink) to the pressure chamber 12. The arrows in Figs. 2A and 2B indicate the flow of the ink.

As illustrated in Fig. 2B, the element substrate 50 in the present embodiment is constituted by laminating the first flow path substrate 20, the second flow path substrate 100, and the third flow path substrate 40 in the vertical (Z) direction. The first flow path substrate 20 is a substrate including the ejection ports 11 for discharging the ink. The second flow path substrate 100 is a substrate in which piezoelectric elements 314 and the pressure chambers 12 are formed. The third flow path substrate 40 is a substrate that isolates the piezoelectric bodies 312 of the piezoelectric elements 314 from the ink, and is a substrate that includes flow paths that supply the ink from the common liquid chamber 14 to the pressure chambers 12.

The liquid ejecting head 4 includes the plurality of piezoelectric elements 314, and the supply flow path 13, the pressure chamber 12, and the ejection port 11, formed corresponding to each of the piezoelectric elements 314. The adjacent pressure chambers 12 are separated by partitions, and are not affected by direct pressure from the adjacent piezoelectric elements 314. The piezoelectric element 314 formed adjacent to an insulation layer 200 serves as a vibration plate.

The ink accommodated in the pressure chamber 12 forms a meniscus at the ejection port 11 in a stable state. In a case where a voltage waveform is applied to the piezoelectric element 314 in accordance with an ejection signal, the piezoelectric element 314 is deformed, and the pressure chamber 12 can be expanded or contracted. By combining the expansion operation and the contraction operation, a droplet (ink droplet) 60 is generated from the meniscus and the droplet is ejected in the -Z direction.

The ink in the pressure chamber 12 consumed by an ejection operation is supplied from the common liquid chamber 14 by the capillary force of the ejection port 11, and reforms a meniscus at the ejection port 11. In the present embodiment, a combination of the ejection port 11, the piezoelectric element 314, and the pressure chamber 12 is referred to as a discharge element.

An example of specific dimensions of the above structure in the present embodiment will be described. Each discharge element, that is, the piezoelectric element 314, the ejection port 11 and the pressure chamber 12, is arranged in the Y direction at a density of 150 nozzles per inch (npi). The size (length) of the piezoelectric element 314 in the X direction may be about 500 µm, and the size (width) of the piezoelectric element 314 in the Y direction may be about 110 µm. The diameter of the ejection port 11 may be 25 µm, the thickness of the ejection port 11 may be 30 µm, and the thickness of the first flow path substrate 20 100 µm. The size (length) of the pressure chamber 12 in the X direction may be 550 µm, the size (width) of the pressure chamber 12 in the Y direction may be 120 µm, and the size (height) of the pressure chamber 12 in the Z direction may be 100 µm. The viscosity of the ink may be 4 cp, and the minimum ink ejection amount from each ejection port 11 may be 3 pL.

In the present embodiment, the drive frequency of each piezoelectric element 314 may be 30 kHz. Such a drive frequency can be appropriately set based on the time required for each discharge element from when voltage is applied to the piezoelectric element 314 until the ink is actually ejected and new ink is refilled to enable the next ejection operation.

The liquid ejecting head 4 is constituted by arranging a plurality of element substrates, each of which is constituted by arranging a plurality of discharge elements. Each of the element substrates is generally connected to a flexible wiring substrate, and is further connected to an electric wiring substrate. The electric wiring substrate is provided with a power supply terminal for supplying power and a signal input terminal for receiving the ejection signal. On the other hand, in an ink supply unit, a circulation flow path is formed that supplies ink containing a color material supplied from an ink tank to individual element substrates, and collects the ink that has not been consumed during printing.

With the above configuration, each discharge element arranged on the element substrate 50 uses power supplied from the power supply terminal based on print data that is input from the signal input terminal to eject the ink supplied from the ink supply unit from the ejection port in the -Z direction. The dimensional values of each part illustrated above are merely examples, and may be changed as appropriate according to the required specifications.

As an example of the liquid ejecting head 4 of the liquid ejecting apparatus, there is an ink jet print head of a printer (image printing apparatus). However, the liquid ejected from the liquid ejecting head 4 is not limited to ink. For example, the liquid ejecting head 4 may eject a primer.

The liquid ejecting head 4 of the liquid ejecting apparatus uses a piezoelectric actuator 600 according to a second embodiment (described herein) that is configured to be deformable by driving the piezoelectric element 314.

### <Comparative Example>

Hereinafter, a schematic diagram of a conventional liquid ejecting head will be used as a comparative example to describe the difficulty of increasing the density of piezoelectric elements due to an increase in the number of wiring lines. Also described are a common wiring line and an individual wiring line.

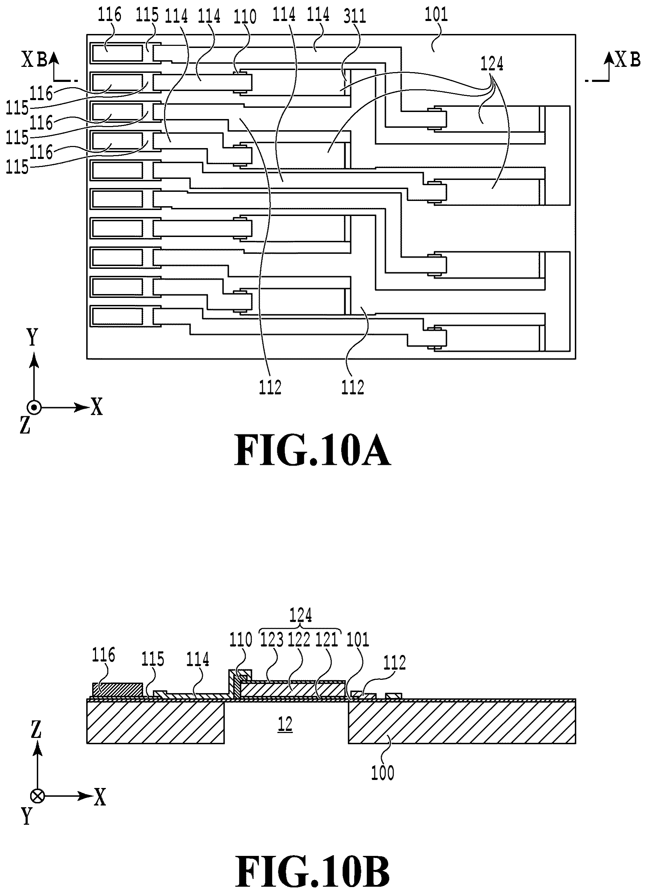

Figs. 10A and 10B are schematic diagrams of a conventional liquid ejecting head. Fig. 10A is a plan view schematically illustrating the liquid ejecting head. Fig. 10B is a cross-sectional view taken along line XB-XB in Fig. 10A.

For clarity and to avoid obscuring understanding of the arrangement of the piezoelectric elements 124, each of wiring lines, and the like, only the second flow path substrate 100 of the element substrate 50 are illustrated in the simplified Figs. 10A and 10B, without illustrating the ejection ports 11 and the supply flow paths 13 illustrated in Figs. 2A and 2B. In the following description, the second flow path substrate 100 may be referred to as the substrate 100.

As illustrated in Figs. 10A and 10B, the conventional liquid ejecting head includes the substrate 100, an insulation layer 101, and the plurality of piezoelectric elements 124. The plurality of piezoelectric elements 124 are formed on an upper surface of the insulation layer 101, and have a structure in which a lower electrode 121, a piezoelectric body 122, and an upper electrode 123 are laminated in this order. The conventional liquid ejecting head illustrated in Figs. 10A and 10B further includes a wiring line 112 connected to the lower electrode 121, a wiring line 114 connected to the upper electrode 123, a pad electrode 115, and a mounting electrode 116. As illustrated in Fig. 10B, the insulation layer 101 that will serve as a vibration plate is formed on the upper surface side of the substrate 100.

The lower electrode 121, the piezoelectric body 122, and the upper electrode 123 are laminated in this order on the upper surface of the insulation layer 101, and the lower electrode 121, the piezoelectric body 122, and the upper electrode 123 form the piezoelectric element 124. The plurality of pressure chambers 12 are formed in the substrate 100 at portions located on the opposite side to the piezoelectric elements 124 so as to correspond to the plurality of piezoelectric elements 124.

As illustrated in Fig. 10A, the plurality of piezoelectric elements 124 are arranged at high density in order to print a high-definition image. For ease of understanding, Fig. 10A illustrates an example in which the piezoelectric elements 124 are arranged in a staggered two-row arrangement in a plane.

As illustrated in Fig. 10A, the wiring line 112 electrically connected to the lower electrode 121 is drawn out to an end portion side of the upper surface of the insulation layer 101 in the -X direction. In addition, the wiring line 112 is connected to the pad electrode 115 on the end portion side in the -X direction and to the mounting electrode 116 formed on an upper surface of the pad electrode 115. In addition, the wiring line 114 electrically connected to the upper electrode 123 is drawn across the insulation layer 110 to the end portion side of the upper surface of the insulation layer 101 in the -X direction. In addition, the wiring line 114 is connected to the pad electrode 115 on the end portion side in the -X direction and to the mounting electrode 116 formed on the upper surface of the pad electrode 115.

The wiring line 112 is drawn out from the lower electrodes 121 of the plurality of piezoelectric elements 124, and may be referred to herein as the common wiring line. In Fig. 10A, the wiring lines drawn from the lower electrodes 121 of four piezoelectric elements 124 join together to form the common wiring line, and the common wiring line is connected to one pad electrode 115. The wiring line 112 has a function of applying a common electric signal to the plurality of piezoelectric elements 124. In the following description, the wiring line 112 will also be referred to as the common wiring line 112.

On the other hand, the wiring line 114 is drawn out from the upper electrode 123 of each piezoelectric element 124, and may be referred to herein as the individual wiring line. In Fig. 10A, the wiring line 114 drawn out from the upper electrode 123 of each piezoelectric element 124 is connected as the individual wiring line to the pad electrode 115 corresponding to the piezoelectric element 124. The wiring line 114, which is the individual wiring line, has a function of applying an electric signal to each of the piezoelectric elements 124. In the following description, the wiring line 114 will also be referred to the individual wiring line 114.

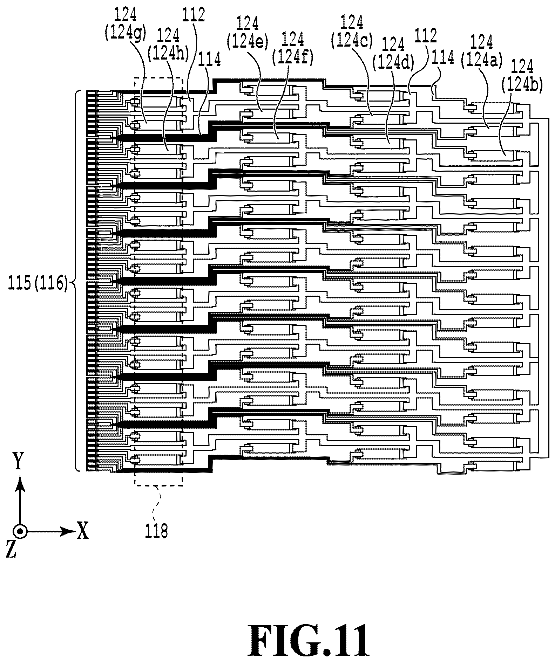

Fig. 11 is a plan view schematically illustrating a conventional liquid ejecting head. In the configuration illustrated in Fig. 11, a greater number of piezoelectric elements 124 are arranged than in Fig. 10A. The liquid ejecting head in Fig. 11 has a plurality of piezoelectric elements 124 having the same structure. For convenience of description, in a case of referring to a piezoelectric element 124a, a piezoelectric element 124b, and the like, each piezoelectric element 124 is distinguished from one another. The piezoelectric element 124 collectively refers to the plurality of piezoelectric elements 124 as illustrated in Fig. 11, including the piezoelectric element 124a, the piezoelectric element 124b, and the like.

In Fig. 11, the piezoelectric elements 124 are arranged in a staggered arrangement in four columns, with one common wiring line 112 arranged for eight piezoelectric elements 124 due to the relationship between the wiring arrangement layout and wiring resistance. The individual wiring line 114 is individually arranged from each of the piezoelectric elements 124 toward the pad electrode 115 arranged in the -X direction. The individual wiring lines 114 of the piezoelectric element 124a and the piezoelectric element 124b are arranged such that each of the two wiring lines is arranged parallel to each other toward the -X direction between the piezoelectric element 124c and the piezoelectric element 124d. The individual wiring lines 114 of the piezoelectric element 124a, the piezoelectric element 124b, the piezoelectric element 124c, and the piezoelectric element 124d are arranged such that the four wiring lines are arranged parallel to each other toward the -X direction between the piezoelectric element 124e and the piezoelectric element 124f. The individual wiring lines 114 of the piezoelectric element 124a, the piezoelectric element 124b, the piezoelectric element 124c, the piezoelectric element 124d, the piezoelectric element 124e, and the piezoelectric element 124f are arranged such that each of the six wiring lines are arranged parallel to each other toward the -X direction between the piezoelectric element 124g and the piezoelectric element 124h. That is, a maximum of six individual wiring lines 114 are arranged between the two piezoelectric elements 124g and 124h that are adjacent in the Y direction. Considering the resistance of the wiring lines, narrowing the width of the individual wiring line 114 has a limitation. Therefore, an increase in the area occupied by the wiring lines due to an increase in the number of wiring lines prevents the density of the piezoelectric elements 124 from being increased. In a case where the number of individual wiring lines 114 is increased, the number of pad electrodes 115 is similarly increased. Thus, the pad electrodes 115 on the end portion side in the -X direction in Fig. 11 also have to be arranged at a high density.

As described above, in the configuration of the conventional liquid ejecting head described as the comparative example using Figs. 10A and 10B and Fig. 11, in a case where more piezoelectric elements 124 are arranged, the number of individual wiring lines 114 for the piezoelectric elements 124 is also increased. Accordingly, the number of individual wiring lines 114 arranged between the adjacent piezoelectric elements 124 is increased, and the proportion of the area occupied by the wiring lines is increased. This is a major obstacle to increasing the density of the piezoelectric elements 124.

### <Configuration of Piezoelectric Actuator>

In the present embodiment, a configuration will be described in which piezoelectric actuators including piezoelectric elements arranged at high density can be arranged at high density by eliminating the common wiring line.

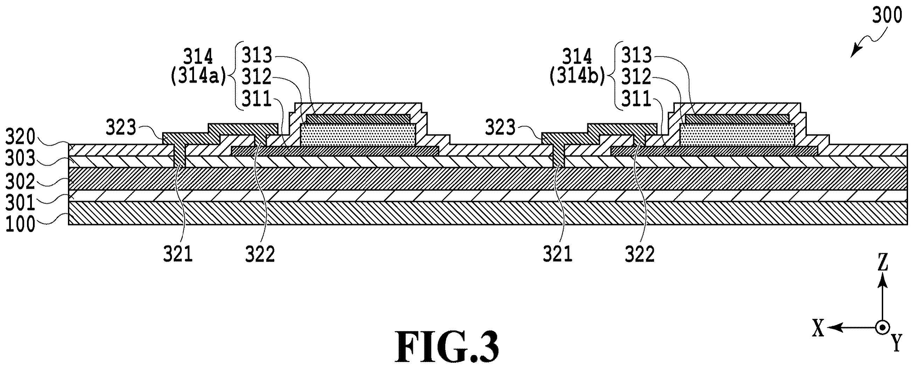

Fig. 3 illustrates a cross-sectional view schematically illustrating the piezoelectric actuator in the present embodiment. A piezoelectric actuator 300 includes a plurality of piezoelectric elements 314a, 314b, each having a same structure. For ease of description, a cross-sectional structure of two piezoelectric elements 314 (314a and 314b) are illustrated in Fig. 3. Since the piezoelectric element 314a and the piezoelectric element 314b have the same structure, and the connection relationship between wiring lines and contact plugs is also the same, the piezoelectric element 314 in the description of Fig. 3 refers to both the piezoelectric element 314a and the piezoelectric element 314b.

As illustrated in Fig. 3, the piezoelectric actuator 300 in the present embodiment includes the substrate 100, an insulation layer 301, a conductive layer 302, an insulation layer 303, the piezoelectric element 314, and an insulation layer 320. The piezoelectric actuator 300 further includes contact plugs 321, contact plugs 322, and wiring lines 323. The insulation layer 301 is also referred to as a first insulation layer 301, the insulation layer 303 is also referred to as a second insulation layer 303, and the insulation layer 320 is also referred to as a third insulation layer 320. The contact plug 321 is also referred to as a first contact plug 321, and the contact plug 322 is also referred to as a second contact plug 322.

The insulation layer 301, the conductive layer 302, and the insulation layer 303 are provided in this order on a surface of the substrate 100. The piezoelectric element 314 is provided on the insulation layer 303. In addition, the piezoelectric element 314 has a structure in which a first electrode (lower electrode) 311, a piezoelectric body 312, and a second electrode (upper electrode) 313 are laminated in this order. The insulation layer 320 is provided so as to cover at least a part of the insulation layer 303, the first electrode 311, the piezoelectric body 312 and the second electrode 313. In other words, the insulation layer 320 is provided so as to cover at least a part of the insulation layer 303 and the piezoelectric element 314.

The contact plug 321 is provided to penetrate the insulation layer 303 and the insulation layer 320. One end (an end portion on the -Z side) of the contact plug 321 is electrically connected to the conductive layer 302. In addition, the contact plug 322 is provided to penetrate the insulation layer 320. One end (an end portion on the -Z side) of the contact plug 322 is electrically connected to an upper surface of the first electrode 311.

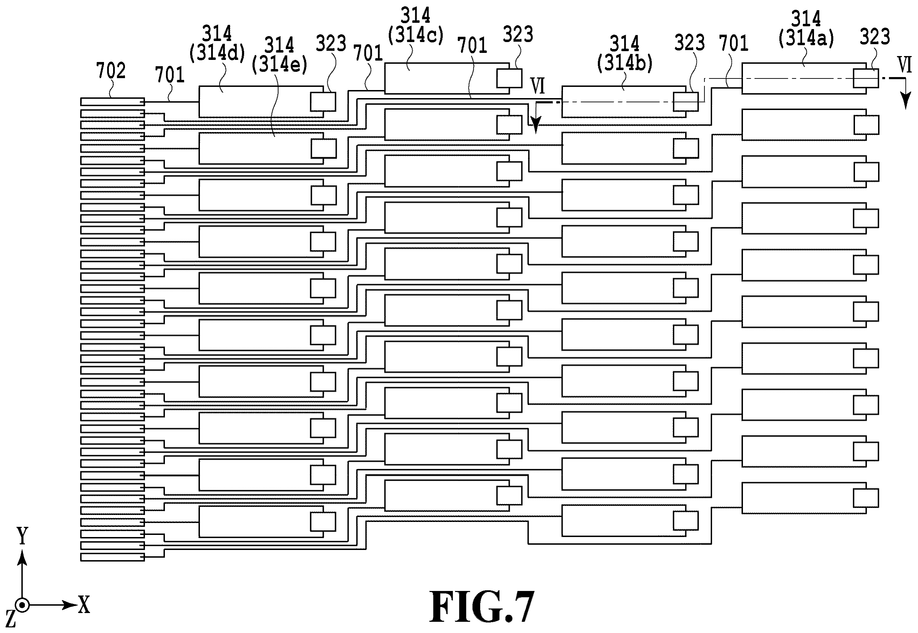

The wiring line 323 is provided on the insulation layer 320. The wiring line 323 electrically connects the other end of the contact plug 321 to the other end of the contact plug 322. The other end of the contact plug 321 refers to the end portion opposite to the end portion electrically connected to the conductive layer 302, that is, the end portion on the +Z side. The other end of the contact plug 322 is the end portion opposite to the end portion electrically connected to the first electrode 311, that is, the end portion on the +Z side. With the configuration as described above, the conductive layer 302 and the first electrode 311 are electrically connected via the contact plug 321, the wiring line 323 and the contact plug 322. As will be described in a manufacturing method, the contact plug 321, the wiring line 323, and the contact plug 322 may be integrally formed by using the same conductive material, as long as they are electrically connected to each other. The piezoelectric element 314 is arranged so as to overlap the conductive layer 302 in plan view (described with reference to Fig. 7). The piezoelectric element 314 and the wiring line 323 are arranged so as to overlap the conductive layer 302 in plan view.

Next, a description will be given of a configuration that is commonly provided to the piezoelectric element 314a arranged on the +X side and the piezoelectric element 314b arranged on the -X side in Fig. 3, and configurations that are individually provided corresponding to the piezoelectric element 314a and the piezoelectric element 314b, respectively. Based on this description, the effects of the present embodiment will be described.

As described above, the piezoelectric element 314a and the piezoelectric element 314b are provided on the insulation layer 303. That is, the substrate 100, the insulation layer 301, the conductive layer 302, and the insulation layer 303 are commonly provided to the piezoelectric element 314a and the piezoelectric element 314b. As illustrated in Fig. 3, the insulation layer 320 is provided so as to cover at least a part of the insulation layer 303, the piezoelectric element 314a, and the piezoelectric element 314b. Thus, the insulation layer 303 is the configuration that is commonly provided to the piezoelectric element 314a and the piezoelectric element 314b.

On the other hand, each of the piezoelectric element 314a and the piezoelectric element 314b individually includes the first electrode 311, the piezoelectric body 312 and the second electrode (the upper electrode) 313. In addition, the contact plug 321, the contact plug 322, and the wiring line 323 are individually provided configurations corresponding to each of the piezoelectric element 314a and the piezoelectric element 314b.

The first electrode 311 of the piezoelectric element 314 a is electrically connected to the conductive layer 302 via the contact plug 321, the wiring line 323 and the contact plug 322. Similarly, the first electrode 311 of the piezoelectric element 314b is electrically connected to the conductive layer 302 via the contact plug 321, the wiring line 323 and the contact plug 322. Thus, the first electrode 311 of the piezoelectric element 314a and the first electrode 311 of the piezoelectric element 314b are electrically connected to the conductive layer 302 that is a commonly provided configuration. Accordingly, the conductive layer 302 can be used as the common wiring line for the piezoelectric element 314a and the piezoelectric element 314b. For example, by applying a bias voltage to the conductive layer 302, a common bias voltage can be applied to the first electrodes 311 of the piezoelectric element 314a and the piezoelectric element 314b. In other words, the conductive layer 302 can be used as the common wiring line for the piezoelectric element 314a and the piezoelectric element 314b. Since the conductive layer 302 functions as the common wiring line, a common wiring line on the insulation layer 320 becomes unnecessary. Accordingly, in the piezoelectric actuator 300 in the present embodiment, the piezoelectric elements 314 can be arranged at high density.

In Fig. 3, although the description has been given by taking the case with two piezoelectric elements 314 as an example, a common wiring line on the insulation layer 320 becomes similarly unnecessary in cases of three or more piezoelectric elements 314. In the piezoelectric actuator 300 having the configuration in the present embodiment, a case where a plurality of piezoelectric elements 314 are provided is the configuration described below.

That is, the piezoelectric actuator 300 with a plurality of piezoelectric elements includes the substrate 100, the insulation layer 301, the conductive layer 302, the insulation layer 303, a plurality of piezoelectric elements 314, and the insulation layer 320. The piezoelectric actuator 300 further includes the contact plug 321, the contact plug 322, and the wiring line 323 that are formed so as to correspond to each of the plurality of piezoelectric elements 314.

The insulation layer 301, the conductive layer 302, and the insulation layer 303 are provided in this order on the surface of the substrate 100. The plurality of piezoelectric elements 314 are provided on the insulation layer 303. In addition, the plurality of piezoelectric elements 314 have the structure in which the first electrode 311, the piezoelectric body 312 and the second electrode 313 are laminated in this order. The insulation layer 320 is provided so as to cover at least a part of the insulation layer 303, as well as the first electrodes 311, the piezoelectric bodies 312, and the second electrodes 313 provided corresponding to the plurality of piezoelectric elements 314. In other words, the insulation layer 320 is provided so as to cover at least a part of the insulation layer 303 and each of the plurality of piezoelectric elements 314.

The contact plug 321 formed corresponding to each of the plurality of piezoelectric elements 314 is provided to penetrate the insulation layer 303 and the insulation layer 320. One end (the end portion on the -Z side) of the contact plug 321 is electrically connected to the conductive layer 302. The contact plugs 322 formed corresponding to each of the plurality of piezoelectric elements 314 is provided to penetrate the insulation layer 320. The one end (the end portion on the -Z side) of the contact plug 322 is electrically connected to the upper surface of the first electrode 311.

The wiring line 323 formed corresponding to each of the plurality of piezoelectric elements 314 is provided on the insulation layer 320. The wiring line 323 electrically connects an other end (the end portion on the +Z side) of the contact plug 321 and an other end (the end portion on the +Z side) of the contact plug 322. Therefore, in each of the plurality of piezoelectric elements 314, the conductive layer 302 and the first electrode 311 are electrically connected via the correspondingly formed contact plug 321, wiring line 323, and contact plug 322. In each of the plurality of piezoelectric elements 314, the contact plug 321, the wiring line 323, and the contact plug 322 may be integrally formed by using the same conductive material, as long as they are electrically connected to each other. The plurality of piezoelectric elements 314 are arranged so as to overlap the conductive layer 302 in plan view (a plan view will be described later in the description of Fig. 7). The plurality of piezoelectric elements 314 and the correspondingly formed wiring lines 323 are respectively arranged so as to overlap the conductive layer 302 in plan view.

With the configuration as described above, all of the first electrodes 311 of the plurality of piezoelectric elements 314 are electrically connected to the conductive layer 302. Thus, in a case where a voltage is supplied to the conductive layer 302, the same voltage can be applied to all of the first electrodes 311 of the plurality of piezoelectric elements 314. That is, in the piezoelectric actuator 300 in the present embodiment, the conductive layer 302 can be used as the common wiring line. Since the conductive layer 302 functions as the common wiring line, a common wiring line on the insulation layer 320 becomes unnecessary. Accordingly, in the piezoelectric actuator 300 in the present embodiment, the piezoelectric elements 314 can be arranged at a higher density.

The substrate 100 can have a flat surface. The material of the substrate 100 is appropriately selected from, for example, silicon, silicon carbide, quartz, gallium nitride, gallium arsenide, indium phosphide, sapphire, and the like.

The insulation layer 301 is provided on the surface of the substrate 100. For the insulation layer 301, for example, silicon oxide, silicon nitride, silicon oxynitride, aluminum oxide, or the like can be used.

The conductive layer 302 is provided on the insulation layer 301. For the conductive layer 302, a conductive semiconductor material such as silicon crystal or polysilicon doped with p-type impurities or n-type impurities can be used. Other than that, any conductive material that does not melt during firing of lead zirconate titanate (PZT), which is a piezoelectric body that will be described later, may be used. For example, metal oxides such as strontium ruthenate (SRO) or lanthanum nickelate (LNO) may be used. Although metals can be used, it is necessary to select materials such as platinum (Pt) and iridium (Ir) that do not melt during firing of the piezoelectric body that will be described later.

Since the conductive layer 302 is not patterned for each individual piezoelectric element, and extends over the entire surface so as to overlap the piezoelectric elements 314 in plan view, the resistivity may be somewhat high. However, in order to be utilized as a conductive material so as to function as a common wiring line as described later, the resistivity can be 100 Ω·cm or less. On the other hand, the conductive layer 302 also serves as a driving portion as a vibration plate in the piezoelectric actuator 300, and therefore needs to have a thickness of 5 µm or less. In addition, in a case where silicon is used for the conductive layer 302, the thickness can be 0.5 µm or more in order to reduce the resistance value. That is, the thickness of the conductive layer 302 can be 0.5 µm or more and 5 µm or less.

For the substrate 100, the insulation layer 301 and conductive layer 302, a silicon on insulator (SOI) substrate may be used. The SOI substrate includes a silicon oxide layer formed on a silicon substrate, and a silicon layer formed on the silicon oxide layer. That is, the silicon substrate can be used as the substrate 100, the silicon oxide layer formed on the silicon substrate can be used as the insulation layer 301, and the silicon layer formed on the silicon oxide layer can be used as the conductive layer 302. The silicon oxide layer of the SOI substrate is also referred to as a buried oxide (BOX) layer. The layer thickness of the silicon oxide layer can be selected between several tens of nanometers to several hundreds of micrometers. In addition, the layer thickness of the silicon layer can be selected relatively freely. In order to function as the conductive layer 302, the silicon layer is doped with p-type impurities or n-type impurities so that the electrical resistivity becomes a desired value.

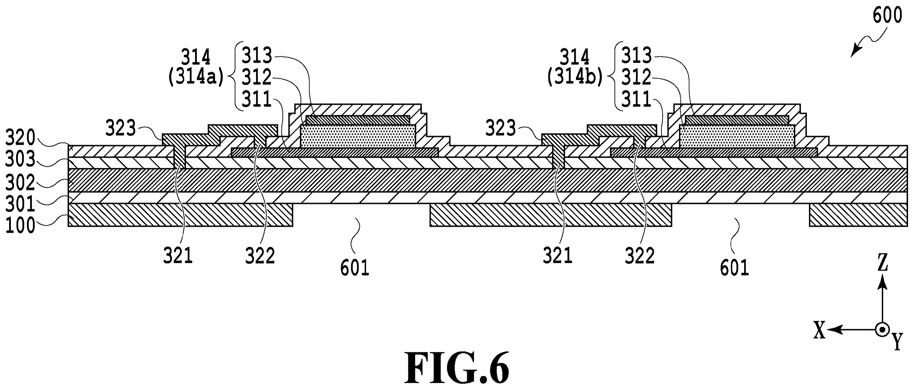

In a case where the SOI substrate is used, if the layer thickness of the silicon oxide layer is appropriately set, it is possible to remove only the silicon substrate by performing selective etching using the silicon oxide layer as an etching stop layer. By such etching, a concave portion 601 having a surface of the silicon oxide layer as a bottom surface is obtained, as described with reference to Fig. 6. Accordingly, the concave portion 601 may have an extremely flat bottom surface that is easily and accurately formed.

The insulation layer 303 is provided on the conductive layer 302. As the material of the insulation layer 303, the same material as the insulation layer 301 can be used.

The first electrode 311 is formed on the insulation layer 303. The first electrode 311 may also be referred to as a bottom electrode. As the material of the first electrode 311, a metal such as copper (Cu), Pt, gold (Au), chromium (Cr), cobalt (Co), or titanium (Ti) can be used. In addition, for the material of the first electrode 311, a metal oxide such as SRO or LNO may be used. Alternatively, the first electrode 311 may be a laminated film using a plurality of metals and metal oxides. For example, the first electrode 311 may be a laminated film of platinum, titanium, and titanium oxide.

In a case where the piezoelectric body 312 is formed in contact with the upper surface of the first electrode 311, the first electrode 311 may also serve as a film that performs control to imitate the crystal orientation of the piezoelectric body 312. In this case, the material of the first electrode 311 is appropriately selected so as to have an appropriate crystal structure depending on the material of the piezoelectric body 312. The film that performs control to imitate the crystal orientation of the piezoelectric body 312 is also referred to as a crystal orientation control film. For example, in a case where the material of the piezoelectric body 312 is lead zirconate titanate, platinum can be used as the material of the first electrode 311 that also serves as the crystal orientation control film. For deposition of the first electrode 311 that uses platinum as its material, a general deposition method such as magnetron sputtering method can be used. During film formation of the first electrode 311, the film thickness of the first electrode 311 is appropriately adjusted so as to obtain the desired orientation of the piezoelectric body 312. In a case where the material of the first electrode 311 is platinum, a laminate or alloy layer of titanium, titanium oxide, or the like may be formed between the first electrode 311 and the insulation layer 303 as an adhesion layer to improve the adhesion between the first electrode 311 and the insulation layer 303.

The piezoelectric body 312 is formed on the upper surface of the first electrode 311. For the material of the piezoelectric body 312, lead zirconate titanate, which is easy to obtain a large amount of displacement, is primarily used. In addition, as the material of the piezoelectric body 312, a piezoelectric material other than lead zirconate titanate can be used. For example, the material of the piezoelectric body 312 may be a piezoelectric material such as barium titanate, lead titanate, lead metaniobate, bismuth titanate, zinc oxide, aluminum nitride, or potassium sodium niobate.

The piezoelectric body 312 is deposited by using a general deposition method such as the sol-gel method, the sputtering method, or application by the spin coating method. The thickness of the piezoelectric body 312 can be about 2 µm. In a case where the piezoelectric body 312 is deposited by application, the piezoelectric body 312 is deposited in several layers. In addition, by performing firing of the piezoelectric body 312 after the deposition of the piezoelectric body 312, the piezoelectric body 312 is oriented in a desired crystal orientation. The firing temperature of the piezoelectric body 312 is appropriately selected depending on the piezoelectric material. In a case where the material of the piezoelectric body 312 is lead zirconate titanate, the firing temperature of the piezoelectric body 312 may be within the range of 600°C to 900°C.

The second electrode 313 is formed on an upper surface of the piezoelectric body 312. As the material of the second electrode 313, a common conductive electrode material can be used. For example, as the material of the second electrode 313, a metal material such as aluminum (Al), tungsten (W), copper, titanium, chromium, gold, or platinum can be used. In addition, as the material of the second electrode 313, a metal oxide such as SRO or LNO may be used. Alternatively, the second electrode 313 may be a laminated film using a plurality of metals and metal oxides.

In a case where the internal stress of the first electrode 311 becomes large during formation of the first electrode 311, and the piezoelectric body 312 is bent, the second electrode 313 may be given an internal stress in the opposite direction to the internal stress of the first electrode 311. Accordingly, the second electrode 313 can be provided with a function of offsetting the stress generated in the piezoelectric body 312. As the material of the second electrode 313 that can provide an internal stress in the opposite direction to the internal stress of the first electrode 311, there is, for example, an alloy of titanium and tungsten.

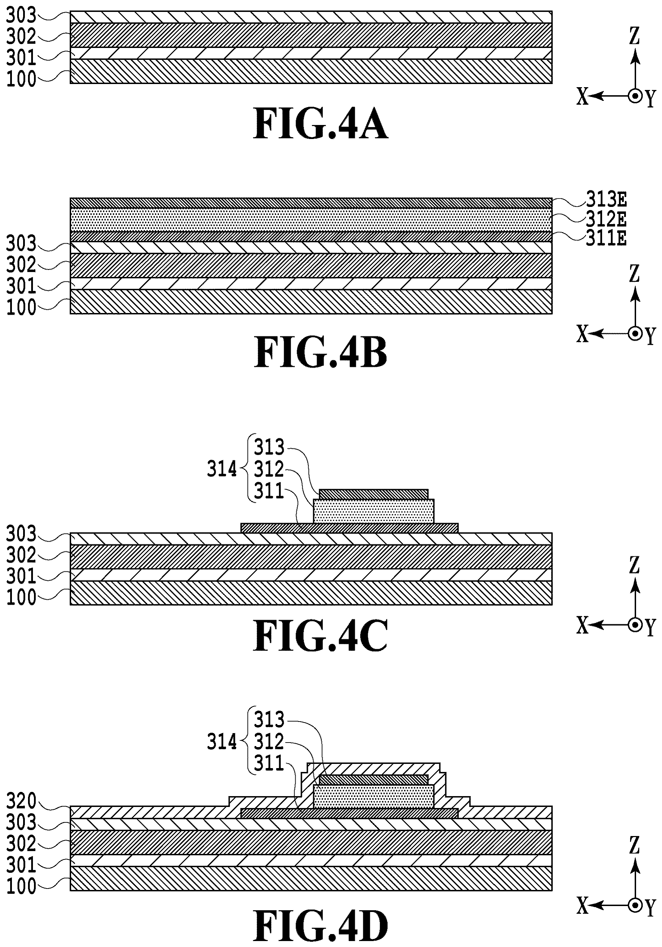

After being deposited, the first electrode 311, the piezoelectric body 312, and the second electrode 313 are processed into a desired shape by patterning. The patterning may be individually performed for the first electrode 311, the piezoelectric body 312, and the second electrode 313, or may be performed separately. For example, the piezoelectric body 312 and the second electrode 313 may be simultaneously patterned, and thereafter the first electrode 311 may be patterned. The patterning will be described in the manufacturing method with reference to Figs. 4A to 4D.

As illustrated in Fig. 3, the second electrode 313 is formed on a part of the piezoelectric body 312. The piezoelectric body 312 is formed on a part of the first electrode 311. In particular, the first electrode 311 is configured to be drawn out in the +X direction relative to the piezoelectric body 312 and the second electrode 313 as illustrated in Fig. 3. In other words, the first electrode 311 has a larger area than the piezoelectric body 312 and has the configuration that is drawn out in the +X direction. This is for connecting the -Z side end portion of the contact plug 322 formed in the Z-axis direction penetrating the insulation layer 320 to the upper surface of the first electrode 311.

The insulation layer 320 is formed so as to cover at least a part of the insulation layer 303, the first electrode 311, the piezoelectric body 312, and the second electrode 313. Similar to the insulation layer 301 provided on the surface of the substrate 100, and to the insulation layer 303 provided on the conductive layer 302, for the material of the insulation layer 320, for example, silicon oxide, silicon nitride, silicon oxynitride, aluminum oxide, or the like can be used. In addition, the material of the insulation layer 320 may be a laminated film of any of silicon oxide, silicon nitride, silicon oxynitride, and aluminum oxide.

The contact plug 321 penetrates the insulation layer 303 and the insulation layer 320, and has the one end (the end portion on the -Z side) electrically connected to the conductive layer 302. The contact plug 322 also penetrates the insulation layer 303, and has the one end (the end portion on the -Z side) electrically connected to the upper surface of the first electrode 311. The wiring line 323 electrically connects the other end (the end portion on the +Z side) of the contact plug 321 and the other end (the end portion on the +Z side) of the contact plug 322. As the material of the wiring line 323, the contact plug 321 and the contact plug 322, a commonly used metal material can be used. For example, as the material of the wiring line 323, the contact plug 321, and the contact plug 322, a metal material such as aluminum, titanium, copper, silver, or gold, or an alloy of any of these can be used. In addition, a laminated film of these may be used.

The wiring line 323, the contact plug 321, and the contact plug 322 may be integrally formed or separately formed, as long as they are electrically connected to each other. In a case where they are integrally formed, a method may be utilized in which contact holes are formed in the insulation layer 303 and the insulation layer 320, a film of conductive material is deposited over an entire surface to fill the contact holes, and then a wiring line shape is patterned, or the dual damascene method may be utilized. In a case where the wiring line 323 and the contact plug 321 and the contact plug 322 are separately formed, the single damascene method may be utilized.

### <Manufacturing Method of Piezoelectric Actuator>

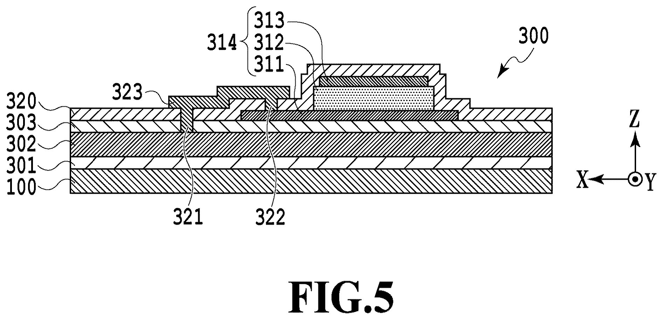

A manufacturing method the piezoelectric actuator 300 in the present embodiment will be described. Figs. 4A to 4D and Fig. 5 are process cross-sectional views illustrating manufacturing processes of the piezoelectric actuator 300.

As illustrated in Fig. 4A, the insulation layer 301, the conductive layer 302, and the insulation layer 303 are formed on the surface of the substrate 100.

In the present embodiment, the SOI substrate is used as the substrate 100, the insulation layer 301, and the conductive layer 302. The SOI substrate includes a silicon wafer (the substrate 100), a silicon oxide layer (the insulation layer 301) formed on the silicon wafer, and a silicon layer formed on the silicon oxide layer (the conductive layer 302). In the process of forming the insulation layer 303 on the silicon layer of the SOI substrate, the SOI substrate is heat-treated to deposit a silicon thermal oxide film on a surface of the silicon layer (the conductive layer 302), thereby forming the insulation layer 303. As described above, the thickness of the conductive layer 302 can be 0.5 µm or more and 5 µm or less. Taking this into consideration, in the present embodiment, the thickness of the conductive layer 302 is set to 2 µm.

Although the SOI substrate is used in the present embodiment, the insulation layer 301 and the conductive layer 302 may be formed by being deposited on the silicon substrate (the substrate 100). As the deposition method, the heat treatment method, the chemical vapor deposition (CVD) method, the sputtering method, and the like can be used. The insulation layer 301 and the insulation layer 303 are not limited to silicon oxide, and may use the above-described materials. Also, the substrate 100 and the conductive layer 302 are not limited to silicon, and may use the above-described materials.

Subsequently, as illustrated in Fig. 4B, a first electrode layer 311E, a piezoelectric body layer 312E, and a second electrode layer 313E are formed on the insulation layer 303 in this order in the +Z direction in an overlapping manner. Hereinafter, the first electrode layer 311E that is the material of the first electrode 311 will be simply referred to as the first electrode layer 311E. The same applies to the piezoelectric body layer 312E and the second electrode layer 313E.

In the process of forming the first electrode layer 311E, platinum, titanium, and titanium oxide are deposited on the insulation layer 303 in an overlapping manner with the sputtering method to form the first electrode layer 311E.

The piezoelectric body layer 312E is formed on the first electrode layer 311E in an overlapping manner with the sol-gel method, and the piezoelectric body layer 312E is fired to achieve a desired crystal orientation. Although the piezoelectric body layer 312E is formed with the sol-gel method using lead zirconate titanate, the sputtering method may be used.

The second electrode layer 313E is formed on the piezoelectric body layer 312E in an overlapping manner with the sputtering method. For the second electrode layer 313E, a metal including platinum, titanium, and tungsten, or a metal oxide such as strontium ruthenate or lanthanum nickelate may be used, or may be a laminated film using a plurality of these metals and metal oxides.

Subsequently, as illustrated in Fig. 4C, patterning is performed to form the piezoelectric element 314 including the first electrode 311, the piezoelectric body 312, and the second electrode 313. The patterning may be performed on the first electrode body layer 311E, the piezoelectric layer 312E, and the second electrode layer 313E simultaneously or separately. In the present embodiment, after the second electrode layer 313E and the piezoelectric body layer 312E are patterned, the first electrode layer 311E is patterned.

The second electrode layer 313E and the piezoelectric body layer 312E are initially patterned to form the second electrode 313 and the piezoelectric body 312. In the process of patterning the second electrode layer 313E and the piezoelectric body layer 312E, a resist pattern is formed on the second electrode layer 313E with the photolithography method so as to have a desired pattern. After forming the resist pattern, portions of the second electrode layer 313E and the piezoelectric body layer 312E other than the portions that will become the second electrode 313 and the piezoelectric body 312 are removed by etching, thereby forming the second electrode 313 and the piezoelectric body 312. For the etching method, the dry etching method is used in the present embodiment, but wet etching method may be used.

Subsequently, the first electrode layer 311E is patterned to form the first electrode 311. In the process of patterning the first electrode layer 311E, a resist pattern is formed again with the photolithography method on the first electrode layer 311E so as to have a desired pattern. After forming the resist pattern, portions of the first electrode layer 311E other than the portion that will become the first electrode 311 are removed by etching. By this etching, the piezoelectric element 314 including the first electrode 311, the piezoelectric body 312 and the second electrode 313 is formed. For the etching method, the dry etching method is used in the present embodiment, but the wet etching method may be used.

In the present embodiment, the first electrode 311, the piezoelectric body 312, and the second electrode 313 may be rectangular shaped having long sides parallel to the X axis, as will be described with reference to Fig. 7, without being so limited. The shapes of the first electrode 311, the piezoelectric body 312 and the second electrode 313 may be, for example, rectangles, parallelograms, circles or ellipses. In addition, the shapes of the first electrode 311, the piezoelectric body 312 and the second electrode 313 may be rectangles or parallelograms with rounded corners.

Subsequently, as illustrated in Fig. 4D, the insulation layer 320 is formed so as to cover the insulation layer 303, the first electrode 311, the piezoelectric body 312, and the second electrode 313. In the present embodiment, for the insulation layer 320, a laminated film of a tetra ethoxy silane (TEOS) film and an aluminum oxide film is formed with the CVD method. The TEOS film and the aluminum oxide film may not be laminated, and a single layer film of either one of these may be used.

Next, as illustrated in Fig. 5, the contact plug 321, the contact plug 322, and the wiring line 323 are formed. First, contact holes for forming the contact plug 321 and the contact plug 322 are formed by patterning utilizing the photolithography method and the etching method. The contact hole for forming the contact plug 321 and the contact hole for forming the contact plug 322 may be formed simultaneously or separately. The contact hole for forming the contact plug 321 is formed so as to penetrate the insulation layer 320 and the insulation layer 303, and expose the upper surface of the conductive layer 302. The contact hole for forming the contact plug 322 is formed so as to penetrate the insulation layer 320, and expose the upper surface of the first electrode 311. For the etching method, the dry etching method is used in the present embodiment, but the wet etching method may be used.

Subsequently, a metal film as a material for the contact plug 321, the contact plug 322, and the wiring line 323 is deposited on the entire surface. In the present embodiment, a laminated film of an aluminum alloy and a titanium alloy is used as the metal film. By depositing the metal film over the entire surface, the metal is embedded in the contact holes. Thus, the contact plug 321 connected to the conductive layer 302 and the contact plug 322 connected to the first electrode 311 are formed. At the same time, the metal film that will be the material for the wiring line 323 is also formed on the insulation layer 320. After the metal film is formed, the wiring line 323 is formed by patterning. In the process of patterning the wiring line 323, a resist pattern is formed on the deposited metal film with the photolithography method so as to have a desired pattern. At this time, in the resist pattern, the resist remains in the portion where the wiring line 323 is to be formed, and the resist is removed from the other portions. Next, the wiring line 323 is formed by removing the portion of the deposited metal film other than the portion that will become the wiring line 323 by etching.

With the above-described processes, the one end of the contact plug 321 is electrically connected to the conductive layer 302. In addition, the one end of the contact plug 322 is electrically connected to the first electrode 311. The wiring line 323 electrically connects the other end of the contact plug 321 and the other end of the contact plug 322. Thus, a configuration can be obtained in which the first electrode 311 that serves as the lower electrode of the piezoelectric element 314 is electrically connected to the conductive layer 302.

In the present embodiment, although the example has been illustrated in which the contact plug 321, the contact plug 322, and the wiring line 323 are integrally formed from the same metal material, the contact plug 321, the contact plug 322, and the wiring line 323 may be separately formed. For example, the single damascene method may be used for each of the contact holes and wiring line grooves, in which a metal material such as copper is deposited with the plating method, and unnecessary portions are removed with the chemical mechanical polishing (CMP) method. In the single damascene method, the contact holes are formed in a thickly formed insulation layer 320 by patterning. Next, a seed layer made of metal is formed on the entire surface by sputtering method or the like, and thereafter a metal material such as copper is deposited on the entire surface by plating to fill the contact holes. Next, the unnecessary metal material (the metal material on the insulation layer 320) is polished and removed with the CMP method, and the contact plug 321 and the contact plug 322 are formed. Thereafter, an insulation layer is further formed, and then wiring line grooves are formed at desired positions by patterning. Subsequently, a seed layer made of metal is formed on the entire surface with the sputtering method or the like, and thereafter a metal material such as copper is deposited on the entire surface with the plating method to fill the wiring line grooves. Next, the unnecessary metal material (the metal material on the insulation layer) is polished and removed with the CMP method to form the wiring line 323.

With the manufacturing processes as described above, the piezoelectric actuator 300 illustrated in Figs. 3 and 5 can be obtained. The piezoelectric actuator 300 can be utilized in a liquid ejecting head, a micro earphone, and the like.

As described above, in the piezoelectric actuator 300 in the present embodiment, the first electrode 311 that is the lower electrode of the piezoelectric element 314 is electrically connected to the conductive layer 302. Accordingly, the conductive layer 302 can be used as the common wiring line for a plurality of piezoelectric elements 314. Since the conductive layer 302 functions as the common wiring line, a common wiring line on the insulation layer 320 becomes unnecessary. Accordingly, in the piezoelectric actuator 300 in the present embodiment, the piezoelectric elements 314 can be arranged at a higher density.

### <<Second Embodiment >>

### <Configuration of Piezoelectric Actuator>

In the first embodiment, the example of the configuration has been described in which the conductive layer 302 is electrically connected to the first electrode 311 that is the lower electrode. In contrast, in a second embodiment, an example of a piezoelectric actuator in which a concave portion is formed in the substrate 100 is provided. An example in which the piezoelectric actuator is applied to a liquid ejecting head will be described. In the following description, configurations similar to or corresponding to those in the first embodiment will be denoted by the same numerals and description thereof are incorporated by reference, with differences from the first embodiment being described.

Fig. 6 illustrates a cross-sectional view schematically illustrating the piezoelectric actuator in the present embodiment. The piezoelectric actuator 600 includes a plurality of piezoelectric elements 314 having the same structure, as in the first embodiment. In Fig. 6, in order to describe a cross-sectional structure in an easy-to-understand manner, two piezoelectric elements 314 (314a and 314b) are illustrated. Since the piezoelectric element 314a and the piezoelectric element 314b have the same structure, and the connection relationship between wiring lines and contact plugs is also the same, the piezoelectric element 314 in the description of Fig. 6 refers to both the piezoelectric element 314a and the piezoelectric element 314b.

The basic configuration of a piezoelectric actuator 600 in the present embodiment is the same as the basic configuration in the first embodiment, but differs in that the substrate 100 includes concave portions 601, as illustrated in Fig. 6. The concave portions 601 are formed below the piezoelectric body 312 (in the -Z direction) on a surface of the substrate 100 opposite to the surface on which the piezoelectric elements 314 are provided. In addition, the concave portions 601 are formed so as to expose the insulation layer 301. The insulation layer 301, the conductive layer 302, and the insulation layer 303 function as a vibration plate. The piezoelectric element 314 is provided directly above (on the +Z side of) the vibration plate. In a case where a voltage is applied to the first electrode 311 and the second electrode 313 to drive the piezoelectric element 314, the vibration plate deforms in the region where the insulation layer 301 is exposed via the concave portion 601. That is, a mechanical action can be generated in the vibration plate.

### <Manufacturing Method of Piezoelectric Actuator>

Since the piezoelectric actuator 600 in the present embodiment differs from the first embodiment in that the substrate 100 includes the concave portions 601, a manufacturing method of the concave portions 601 will be described. In the present embodiment, as in the first embodiment, the SOI substrate is used as the substrate 100, the insulation layer 301, and the conductive layer 302. If the silicon oxide layer (the insulation layer 301) is used as an etching stop layer, it is possible to remove only the silicon single crystal (the substrate 100) by performing selective etching. By such patterning using etching, the concave portions 601 are obtained in which a surface of the silicon oxide layer (the insulation layer 301) is exposed as a bottom surface, as illustrated in Fig. 6. Accordingly, the concave portions 601 may be an extremely flat bottom surface that is easily and accurately formed. In this manner, the piezoelectric actuator 600 in the present embodiment can be obtained.

### <Configuration of Liquid Ejecting Head>

In a case where the piezoelectric actuator 600 in the present embodiment is applied to a liquid ejecting head, the concave portions 601 function as the pressure chambers 12 (Fig. 2B). That is, the substrate 100 serves as the second flow path substrate 100. By deforming the vibration plate including the insulation layer 301, the conductive layer 302, and the insulation layer 303 by the piezoelectric element 314, the liquid (ink) in the pressure chamber 12 can be pressurized and droplets (ink droplets) can be ejected from a nozzle.

Fig. 7 is a plan view schematically illustrating a liquid ejecting head that uses the piezoelectric actuator 600 in the present embodiment. The flow path configuration of the liquid ejecting head is described with reference to Figs. 2A and 2B. Fig. 6 is a cross-sectional view taken along line VI-VI in Fig. 7. VI-VI has a bent portion midway, with the bent portion corresponding to an intermediate portion between the piezoelectric element 314a and the piezoelectric element 314b in Fig. 6. As can be seen from Fig. 7 together with its cross-sectional view in Fig. 6, the plurality of piezoelectric elements 314 are arranged so as to overlap the conductive layer 302 in plan view. In other words, the conductive layer 302 extends, below the piezoelectric element 314, over the entire region where the piezoelectric element 314 is formed in plan view. This also applies to the piezoelectric actuator 300 that has the configuration without the concave portions 601.

The liquid ejecting head in Fig. 7 includes the plurality of piezoelectric elements 314 having the same structure. For convenience of description, in a case of referring to the piezoelectric element 314a, the piezoelectric element 314b, and the like, the individual piezoelectric elements are distinguished from one another. In the description of Fig. 7, the piezoelectric element 314 collectively refers to a plurality of piezoelectric elements, including the piezoelectric element 314a, the piezoelectric element 314b, and the like.

As illustrated in Fig. 7, in the liquid ejecting head, the plurality of piezoelectric elements 314 are arranged at high density in order to print high-definition images. In Fig. 7, similar to Fig. 11, the individual piezoelectric elements 314 are arranged in a staggered arrangement in four columns.

The first electrode 311 of each piezoelectric actuator 600 in the present embodiment is electrically connected to the underlying conductive layer 302 via the contact plug 321, the wiring line 323, and the contact plug 322. That is, the first electrodes 311 of all the piezoelectric elements 314 are electrically connected to the conductive layer 302. Thus, the conductive layer 302 functions as the common wiring line. Therefore, in the liquid ejecting head in Fig. 7, there is no common wiring line between the piezoelectric elements 314. Accordingly, the arrangement of individual wiring lines 701 differs from that in the comparative example (the conventional liquid ejecting head) illustrated in Fig. 11. In the comparative example in Fig. 11, there are up to six individual wiring lines 114 in the space between the piezoelectric elements 124, but in Fig. 7 illustrating the present embodiment, the individual wiring lines 114 are divided into sets of three wiring lines as the individual wiring lines 701 and are arranged in the space created by the absence of the common wiring line 112.

In Fig. 7, the individual wiring lines 701 are individually arranged from respective piezoelectric elements 314 toward pads 702 arranged in the -X direction. In addition, each individual wiring line 701 is individually connected to a corresponding pad 702. As illustrated in Fig. 7, the number of the individual wiring lines 701 arranged between two piezoelectric elements 314 that are adjacent in the Y direction is up to three. In other words, three individual wiring lines 701 are arranged between the piezoelectric elements 314 that are arranged closest to the pads 702. Specifically, each of the three individual wiring lines 701 of the piezoelectric element 314a, the piezoelectric element 314b, and the piezoelectric element 314c is arranged parallel to each other toward the -X direction between a piezoelectric element 314d and a piezoelectric element 314e. In contrast, in the case of the conventional liquid ejecting head illustrated in Fig. 11, as described above, the number of the individual wiring lines 114 arranged between two piezoelectric elements 314 that are adjacent in the Y direction is up to six. Thus, in a case where the piezoelectric elements 314 are arranged in a staggered arrangement in four columns, in a liquid ejecting head to which the piezoelectric actuator 600 in the present embodiment is applied, the maximum number of individual wiring lines arranged between adjacent piezoelectric elements 314 can be reduced to 1/2 of that of the conventional liquid ejecting head. Accordingly, the piezoelectric elements 314 can be arranged at a higher density.

The effects of the present embodiment will be further described using numerical examples. As described above, in the case where the piezoelectric elements 314 are arranged in the staggered arrangement in four columns, the number of individual wiring lines between two piezoelectric elements 314 that are adjacent in the Y direction can be reduced from six to three. Accordingly, in a case where the line and space (L/S) is 5 µm, the liquid ejecting head using the piezoelectric actuator 600 in the present embodiment can reduce the space in the Y-axis direction by 30 µm, compared to the conventional liquid ejecting head. In addition, in the liquid ejecting head using the piezoelectric actuator 600 in the present embodiment, 150 dots per inch (dpi) per line can be increased in definition degree by approximately 1.2 to 1.5 times. That is, by applying the piezoelectric actuator 600 in the present embodiment to a liquid ejecting head, for example, 150 dpi per line in a conventional case can be increased in definition degree to 180 to 225 dpi. One row refers to a portion 118 surrounded by a dotted line in Fig. 11.

In the liquid ejecting head according to the present embodiment, in a case where a bias voltage is applied to the conductive layer 302 from, for example, a pad to which a voltage supply source is connected, the bias voltage is applied to the first electrodes 311 that are the lower electrodes of all the piezoelectric elements 314. That is, the conductive layer 302 functions as the common wiring line. On the other hand, a usage form is possible in which a voltage signal that forms a drive waveform for the piezoelectric elements 314 is applied to the individual wiring lines 701, thereby driving the individual piezoelectric elements 314 to eject liquid (ink).

As described above, by applying the piezoelectric actuator 600 in the present embodiment to a liquid ejecting head, it is possible to provide the conductive layer 302 with a function of the common wiring line. Accordingly, the common wiring lines arranged between the piezoelectric elements 314 can be eliminated, and the piezoelectric elements 314 can be arranged at a higher density. The greater the number of piezoelectric elements 314, the greater the effects of reducing the number of wiring lines.

### <<Third Embodiment >>

In the first embodiment, the example of the configuration has been described in which the conductive layer 302 is electrically connected to the first electrode 311 that is the lower electrode. In contrast, in a third embodiment, an example of a configuration will be described in which the conductive layer 302 is electrically connected to the second electrode 313 that is the upper electrode. In the following description, configurations similar to or corresponding to those in the first embodiment will be denoted by the same numerals and description thereof is incorporated by reference, with differences from the first embodiment being described.

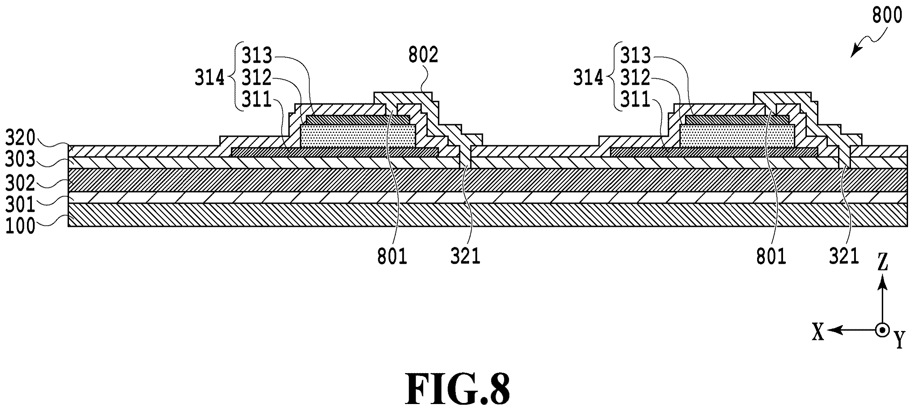

Fig. 8 illustrates a cross-sectional view schematically illustrating a piezoelectric actuator in the present embodiment. A piezoelectric actuator 800 includes a plurality of piezoelectric elements 314 having the same structure, but a description will be given by illustrating two piezoelectric elements 314 in Fig. 8 as in the first embodiment.

The piezoelectric actuator 800 in the present embodiment includes contact plugs 801 and wiring lines 802, but does not include the contact plug 322. The other configuration is the same as that of the piezoelectric actuator 300 in the first embodiment.

The contact plug 321 is provided to penetrate the insulation layer 303 and the insulation layer 320, as in the first embodiment. The one end (the end portion on the -Z side) of the contact plug 321 is electrically connected to the conductive layer 302.

The contact plug 801 is provided to penetrate the insulation layer 320. One end (an end portion on the -Z side) of the contact plug 801 is electrically connected to an upper surface of the second electrode 313. The contact plug 322 in the first embodiment has the one end electrically connected to the upper surface of the first electrode 311, but the contact plug 801 in the present embodiment differs in that the one end is electrically connected to the upper surface of the second electrode 313. That is, one end of the contact plug (322, 801) may be electrically connected to either one of the first electrode 311 or the second electrode 313. Thus, the contact plug 801 may also be referred to as a second contact plug, similar to the contact plug 322. That is, one end of the second contact plug 801 (322) is electrically connected to either one of the first electrode 311 or the second electrode 313.

The wiring line 802 is provided on the insulation layer 320. The wiring line 802 electrically connects the other end of the contact plug 321 and the other end of the contact plug 801. The other end of the contact plug 321 is the end portion opposite to the end portion electrically connected to the conductive layer 302, that is, the end portion on the +Z side. The other end of the contact plug 801 is the end portion opposite to the end portion electrically connected to the second electrode 313, that is, the end portion on the +Z side. With the configuration as described above, the conductive layer 302 and the second electrode 313 are electrically connected via the contact plug 321, the wiring line 802 and the contact plug 801. The contact plug 321, the wiring line 802, and the contact plug 801 may be integrally formed by using the same conductive material, as long as they are electrically connected to each other. The piezoelectric elements 314 are disposed so as to overlap the conductive layer 302 in plan view, which is also the same as in the above-described embodiments. The piezoelectric elements 314 and the wiring lines 802 are arranged so as to overlap the conductive layer 302 in plan view, similar to the above-described embodiments.

In both of the two piezoelectric elements 314 in Fig. 8, the second electrode 313 is electrically connected to the conductive layer 302 via the contact plug 801, the wiring line 802 and the contact plug 321. Thus, both of the piezoelectric elements 314 are electrically connected to the conductive layer 302 on which the second electrodes 313 are commonly provided. Accordingly, the conductive layer 302 can be used as the common wiring line for the two piezoelectric elements 314. Since the conductive layer 302 functions as the common wiring line, a common wiring line on the insulation layer 320 becomes unnecessary. Accordingly, in the piezoelectric actuator 800 in the present embodiment, the piezoelectric elements 314 can be arranged at high density. Since the present embodiment has effects similar to those in the first embodiment, it can be said that the second contact plug 801 (322) has similar effects as long as one end thereof is electrically connected to either one of the first electrode 311 or the second electrode 313.

The piezoelectric actuator 300 can be utilized in a liquid ejecting head, a micro earphone, and the like. In the piezoelectric actuator 800 in the present embodiment, the concave portions 601 as in the second embodiment may be formed in the substrate 100. By forming the concave portions 601 in the substrate 100 of the piezoelectric actuator 800, and making them function as the pressure chambers 12 and applying them to a liquid ejecting head, the effects similar to those in the second embodiment can be obtained. The configuration and effects of the present embodiment have been described by taking the two piezoelectric elements 314 in Fig. 8 as an example, but also in cases where there are three or more piezoelectric elements 314, greater effects can be achieved, as in the above-described embodiments.

### <<Fourth Embodiment >>

In the first embodiment, the example of the configuration has been described in which the conductive layer 302 and the upper surface of the first electrode 311 serving as the lower electrode are electrically connected via the contact plug 321, the wiring line 323 and the contact plug 322. In contrast, in a fourth embodiment, an example of a configuration will be described in which the conductive layer 302 and a lower surface of the first electrode 311 serving as the lower electrode are electrically connected via a contact plug 901. That is, the first embodiment and the present embodiment are common in that the conductive layer 302 is electrically connected to the first electrode 311 that is the lower electrode, but their connection methods are different. In the following description, configurations similar to or corresponding to those in the first embodiment will be denoted by the same numerals and description thereof is incorporated by reference, with differences from the first embodiment being described.

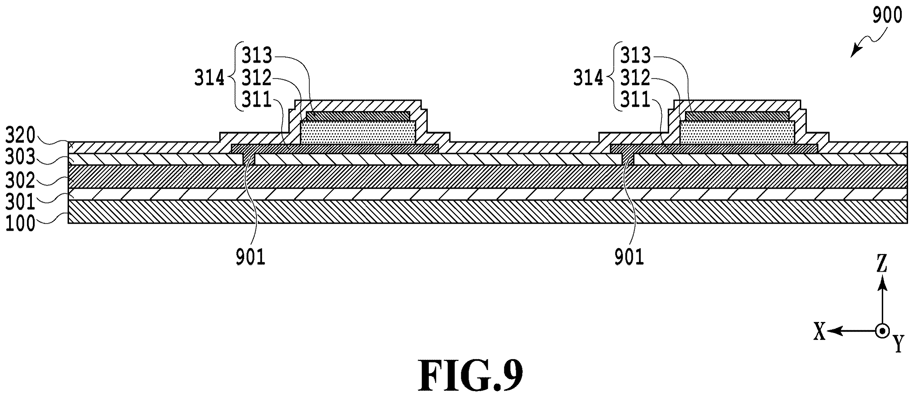

Fig. 9 illustrates a cross-sectional view schematically illustrating a piezoelectric actuator in the present embodiment. A piezoelectric actuator 900 includes a plurality of piezoelectric elements 314 having the same structure, but a description will be given by illustrating two piezoelectric elements 314 in Fig. 9 as in the first embodiment.

The piezoelectric actuator 900 in the present embodiment includes contact plugs 901, but does not include the contact plug 321, the contact plug 322, and the wiring line 323. The other configuration is the same as that of the piezoelectric actuator 300 in the first embodiment. The contact plug 901 is also referred to as a third contact plug 901.

The contact plug 901 is arranged between the first electrode 311 and the conductive layer 302, and is provided to penetrate the insulation layer 303. One end (an end portion on the -Z side) of the contact plug 901 is electrically connected to the conductive layer 302. In addition, the other end of the contact plug 901 (the end portion opposite to the end portion electrically connected to the conductive layer 302, that is, the end portion on the +Z side) is electrically connected to the lower surface of the first electrode 311. Therefore, the conductive layer 302 and the first electrode 311 are electrically connected via the contact plug 901. The contact plug 901 and the first electrode 311 may be integrally formed by using the same conductive material, as long as they are electrically connected to each other. In addition, the piezoelectric element 314 is arranged so as to overlap the conductive layer 302 in plan view, which is also the same as in the above-described embodiments.

In both of the two piezoelectric elements 314 in Fig. 9, the first electrode 311 is electrically connected to the conductive layer 302 via the contact plug 901. Thus, the first electrodes 311 of both of the piezoelectric elements 314 are electrically connected to the conductive layer 302 that is a commonly provided configuration. Accordingly, the conductive layer 302 can be used as the common wiring line for the two piezoelectric elements 314. Since the conductive layer 302 functions as the common wiring line, a common wiring line on the insulation layer 320 becomes unnecessary. Accordingly, in the piezoelectric actuator 900 in the present embodiment, the piezoelectric elements 314 can be arranged at high density.

In Fig. 9, although the description has been given by taking the case with two piezoelectric elements 314 as an example, a common wiring line on the insulation layer 320 becomes similarly unnecessary also in cases where there are three or more piezoelectric elements 314. In the piezoelectric actuator 900 having the configuration of the present embodiment, a case where a plurality of piezoelectric elements 314 are provided is described below, with description of the same or similar configurations as those in the first embodiment being incorporated by reference or simplified, as described herein.

That is, the piezoelectric actuator 900 including a plurality of piezoelectric elements includes the substrate 100, the insulation layer 301, the conductive layer 302, the insulation layer 303, a plurality of piezoelectric elements 314, and the insulation layer 320. The piezoelectric actuator 900 further includes contact plugs 901 formed corresponding to the plurality of piezoelectric elements 314, respectively, but does not include the contact plug 321, the contact plug 322, and the wiring line 323.

The contact plugs 901 formed corresponding to the plurality of piezoelectric elements 314 are arranged between the first electrodes 311 and the conductive layer 302, and are provided to penetrate the insulation layer 303. The one end (the end portion on the -Z side) of the contact plug 901 is electrically connected to the conductive layer 302. In addition, the other end (the end portion on the +Z side) of the contact plug 901 is electrically connected to the lower surface of the first electrode 311. Therefore, the conductive layer 302 and the first electrode 311 are electrically connected via the contact plug 901. The contact plug 901 and the first electrode 311 may be integrally formed by using the same conductive material, as long as they are electrically connected to each other. In addition, the plurality of piezoelectric elements 314 are arranged so as to overlap the conductive layer 302 in plan view.

With the above-described configuration, the first electrode 311 of each of the plurality of piezoelectric elements 314 is electrically connected to the conductive layer 302 via the contact plug 901. That is, the first electrodes of all of the plurality of piezoelectric elements 314 are electrically connected to the conductive layer 302 that is a commonly provided configuration. Accordingly, the conductive layer 302 can be used as the common wiring line for the plurality of piezoelectric elements 314. Since the conductive layer 302 functions as the common wiring line, a common wiring line on the insulation layer 320 becomes unnecessary. Accordingly, in the piezoelectric actuator 900 in the present embodiment, the piezoelectric elements 314 can be arranged at a higher density. In addition, the piezoelectric actuator 900 in the present embodiment does not require the wiring line 323 and has a small number of contact plugs, and therefore has the advantage of requiring fewer manufacturing processes.

The piezoelectric actuator 300 can be utilized in a liquid ejecting head, a micro earphone, and the like. In addition, also in the piezoelectric actuator 900 in the present embodiment, the concave portions 601 as in the second embodiment may be formed in the substrate 100. By forming the concave portions 601 in the substrate 100 of the piezoelectric actuator 900, and making them function as the pressure chambers 12 and applying them to a liquid ejecting head, the effects similar to those in the second embodiment can be obtained.

### <<Other Embodiments>>

In each of the above-described embodiments, the example of the configuration has been described in which either one of the first electrode 311 that is the lower electrode or the second electrode 313 that is the upper electrode is electrically connected to the conductive layer 302, thereby allowing the conductive layer to function as a common wiring line. In addition, as for the connection method in the case where the first electrode 311 that is the lower electrode is electrically connected to the conductive layer 302, the description has been given of the examples of the configuration in which the contact plug 322 is connected to the upper surface of the first electrode 311, and the configuration in which the contact plug 901 is connected to the lower surface of the first electrode 311. However, in a piezoelectric actuator including a plurality of piezoelectric elements 314, the configuration of the same embodiment may not be applied to all of the piezoelectric elements 314, but may be applied in combination with the configuration of another embodiment. For example, in one piezoelectric actuator, for a part of the piezoelectric elements 314, the upper surface of the first electrode 311 and the conductive layer 302 are electrically connected by the configuration of the first embodiment. In addition, for the other piezoelectric elements 314, the lower surface of the first electrode 311 and the conductive layer 302 may be electrically connected by using the configuration of the third embodiment.

Various embodiments have been described in detail above but it will be understood that the present disclosure is not limited to these embodiments and encompasses all modifications, variants, alternatives and equivalents falling within the scope of the appended claims.

## Claims

1. A piezoelectric actuator comprising:
a first insulation layer (301) provided on a surface of a substrate (100);
a conductive layer (302) provided on the first insulation layer;
a second insulation layer (303) provided on the conductive layer;
a piezoelectric element (314) provided on a part of the second insulation layer, the piezoelectric element including a first electrode (311), a piezoelectric body (312), and a second electrode (313) in this order;
a third insulation layer (320) covering at least a part of the second insulation layer, the first electrode, the piezoelectric body and the second electrode;
a first contact plug (321) penetrating the second insulation layer and the third insulation layer, and having one end electrically connected to the conductive layer;
a second contact plug (322) penetrating the third insulation layer, and having one end electrically connected to either one of the first electrode or the second electrode; and
a wiring line (323) provided on the third insulation layer, and electrically connecting another end of the first contact plug and another end of the second contact plug.

2. The piezoelectric actuator according to claim 1, wherein the first contact plug, the second contact plug, and the wiring line are integrally formed.

3. The piezoelectric actuator according to claim 1 or 2, wherein the piezoelectric element is arranged to overlap the conductive layer in plan view.

4. The piezoelectric actuator according to any one of claims 1 to 3, wherein the conductive layer is silicon.

5. The piezoelectric actuator according to any one of claims 1 to 4, wherein the first insulation layer and the second insulation layer are silicon oxide.

6. The piezoelectric actuator according to any one of claims 1 to 5, wherein the substrate, the first insulation layer, and the conductive layer are a silicon on insulator substrate.

7. The piezoelectric actuator according to any one of claims 1 to 6, wherein a thickness of the conductive layer is 0.5 µm or more and 5 µm or less.

8. The piezoelectric actuator according to any one of claims 1 to 7, wherein resistivity of the conductive layer is 100 Ω·cm or less.

9. The piezoelectric actuator according to any one of claims 1 to 8, further comprising:
a concave portion formed, on a surface of the substrate opposite to a surface on which the piezoelectric element is provided, wherein
the concave portion is configured to expose the first insulation layer, and
the surface is below the piezoelectric body.

10. A piezoelectric actuator comprising:
a first insulation layer (301) provided on a surface of a substrate (100);
a conductive layer (302) provided on the first insulation layer;
a second insulation layer (303) provided on the conductive layer;
a piezoelectric element (314) provided on a part of the second insulation layer, the piezoelectric element including a first electrode (311), a piezoelectric body (312), and a second electrode (313) in this order; and
a contact plug (901) arranged between the first electrode and the conductive layer, penetrating the second insulation layer, having one end electrically connected to the conductive layer and another end electrically connected to the first electrode.

11. The piezoelectric actuator according to claim 10, wherein the first electrode and the contact plug are integrally formed.

12. The piezoelectric actuator according to claim 10 or 11, wherein the piezoelectric element is arranged to overlap the conductive layer in plan view.

13. The piezoelectric actuator according to any one of claims 10 to 12, wherein the conductive layer is silicon.

14. The piezoelectric actuator according to any one of claims 10 to 13, wherein the first insulation layer and the second insulation layer are silicon oxide.

15. The piezoelectric actuator according to any one of claims 10 to 14, wherein the substrate, the first insulation layer, and the conductive layer are a silicon on insulator substrate.

16. The piezoelectric actuator according to any one of claims 10 to 15, wherein a thickness of the conductive layer is 0.5 µm or more and 5 µm or less.

17. The piezoelectric actuator according to any one of claims 10 to 16, wherein resistivity of the conductive layer is 100 Ω·cm or less.

18. The piezoelectric actuator according to any one of claims 10 to 17, further comprising:
a concave portion formed, on a surface of the substrate opposite to a surface on which the piezoelectric element is provided, wherein
the concave portion is configured to expose the first insulation layer, and
the surface is below the piezoelectric body.

19. A liquid ejecting head including a piezoelectric actuator,
the piezoelectric actuator comprising:
a first insulation layer (301) provided on a surface of a substrate (100);
a conductive layer (302) provided on the first the insulation layer;
a second insulation (303) layer provided on the conductive layer;
a piezoelectric element (314) provided on a part of the second insulation layer, the piezoelectric element including a first electrode (311), a piezoelectric body (312), and a second electrode (313) in this order;
a third insulation layer (320) covering at least a part of the second insulation layer, the first electrode, the piezoelectric body and the second electrode;
a first contact plug (321) penetrating the second insulation layer and the third insulation layer, and having one end electrically connected to the conductive layer;
a second contact plug (322) penetrating the third insulation layer, and having one end electrically connected to either one of the first electrode or the second electrode; and
a wiring line (323) provided on the third insulation layer, and electrically connecting another end of the first contact plug and another end of the second contact plug.
